# EUROPEAN PATENT APPLICATION

(11) **EP 4 776 798 A1**
(43) Date of publication of application: **15.07.2026**
(21) Application number: 26150066.4
(22) Date of filing: 02.01.2026
(51) Int. Cl.: H10F 77/20, H10F 19/90

(54) **BACK-CONTACT CELL**

(30) Priority: 06.01.2025 CN 202510018824
(71) Applicant: JINKO SOLAR CO., LTD, ShangRao, Jiangxi 334100 (CN); Zhejiang Jinko Solar Co., Ltd., Haining, Zhejiang (CN)
(72) Inventor: ZHANG, Chenming, Shangrao, Jiangxi, 334100 (CN); XIA, Zhipeng, Shangrao, Jiangxi, 334100 (CN); LU, Sitian, Shangrao, Jiangxi, 334100 (CN); HUANG, Jide, Shangrao, Jiangxi, 334100 (CN); LIU, Changming, Shangrao, Jiangxi, 334100 (CN); ZHANG, Xinyu, Shangrao, Jiangxi, 334100 (CN); JIN, Hao, Shangrao, Jiangxi, 334100 (CN)
(74) Representative: Balder IP Law, S.L.

(57) **Abstract**

A back-contact cell and a photovoltaic module are provided. The back-contact cell includes: a cell base; a plurality of busbars, at least one edge pad, a plurality of intermediate pads, at least one first interconnect line, a plurality of second interconnect lines, which are disposed on the cell base. The plurality of busbars include two edge busbars and a plurality of intermediate busbars positioned between the two edge busbars. A respective edge pad of the at least one edge pad is closest to and electrically connected to one of the two edge busbars via a respective one of the plurality of first interconnect line, intermediate pads in a respective column are in direct contact with a respective intermediate busbar, a respective edge busbar of the two edge busbars is electrically connected to at least one intermediate busbar of the plurality of intermediate busbars via one or more second interconnect lines.

## Description

### TECHNICAL FIELD

The present disclosure relates to the field of photovoltaic cells, and in particular to a back-contact cell and a photovoltaic module.

### BACKGROUND

With the gradual depletion of fossil energy resources, photovoltaic cells have become increasingly popular as a new alternative energy solution. A photovoltaic cell is a device that converts solar energy into electrical energy. The photovoltaic cell generates carriers using the photovoltaic effect and then utilizes electrodes to extract the carriers, thereby enabling the effective utilization of electrical energy.

A back-contact cell is a type of cell where both positive busbars and negative busbars are arranged on the backside (non-light-receiving surface) of the cell. The light-receiving surface of the cell is free from obstruction by any metal busbars, which effectively increases the short-circuit current of the back-contact cell. Meanwhile, the backside allows for wider metal busbars to reduce series resistance, thereby improving the fill factor. Additionally, such cells with an unobstructed front side not only offer high conversion efficiency but also have a more aesthetically pleasing appearance, and modules with full backside electrodes are easier to assemble.

However, the back-contact solar cell has relatively weak current collection capability, which hinders the improvement of photoelectric conversion efficiency.

### SUMMARY

In an embodiment of the present disclosure, a back-contact cell and a photovoltaic module are provided, which are at least beneficial to improving the efficiency of the back-contact cell.

According to some embodiments of the present disclosure, in an aspect, a back-contact cell is provided, and the back-contact cell includes a cell base, a plurality of busbars, at least one edge pad, a plurality of intermediate pads, at least one first interconnect line and a plurality of second interconnect lines on the cell base. The plurality of busbars are arranged at intervals in a first direction, and extend in a second direction intersecting the first direction. The plurality of busbars include two edge busbars and a plurality of intermediate busbars positioned between the two edge busbars, where a respective edge pad of the at least one edge pad is closest to and electrically connected to one of the two edge busbars via a respective one of the at least one first interconnect line. The plurality of intermediate pads form a plurality of columns spaced apart in the first direction, and intermediate pads in a respective column of the column are electrically connected to a respective intermediate busbar of the plurality of intermediate busbars. A respective edge busbar of the two edge busbars is electrically connected to at least one intermediate busbar of the plurality of intermediate busbars via one or more second interconnect lines of the plurality of second interconnect lines.

In some embodiments, the back-contact cell further includes a plurality of columns, and each column including fingers extending in the first direction and arranged at intervals in the second direction, where a respective busbar of the plurality of busbars is positioned between and electrically connected to first fingers in a first column and second fingers in a second column adjacent to the first column.

In some embodiments, in the second direction, a respective first interconnect line of the at least one first interconnect line has a first width, a respective finger of the plurality of fingers has a second width, and the first width is greater than the second width.

In some embodiments, in the second direction, a respective second interconnect line of the plurality of second interconnect lines has a third width, and the third width is greater than the second width.

In some embodiments, the plurality of intermediate busbars include two first intermediate busbars respectively adjacent to one of the two edge busbars; a respective first intermediate busbar of the two first intermediate busbars includes a plurality of first portions spaced apart in the second direction; and a respective second interconnect line of the plurality of second interconnect lines extends along the first direction and is positioned between two adjacent first portions of the plurality of first portions.

In some embodiments, the plurality of intermediate busbars further includes a plurality of second intermediate busbars other than the first intermediate busbars; and the plurality of second intermediate busbars are positioned between the two first intermediate busbars.

In some embodiments, the respective second interconnect line is electrically connected to one of the plurality of second intermediate busbars that is closest to the respective first intermediate busbar.

In some embodiments, at least one of the plurality of second intermediate busbars includes a plurality of second portions spaced apart in the second direction, and the respective second interconnect line is electrically connected to at least one second portion of the plurality of second portions.

In some embodiments, one part of the second intermediate busbars includes the plurality of second portions, and the other part of the second intermediate busbars are integral second intermediate busbars; and in the first direction, a respective second portion of the second portions has a fourth width, and a respective one of the integral second intermediate busbars has a fifth width, and the fourth width is less than the fifth width.

In some embodiments, all the second intermediate busbars include the plurality of second portions grouped into rows; and the respective second interconnect line is electrically connected to second portions in a same row of rows.

In some embodiments, the respective edge busbar includes a third portion and two fourth portions spaced apart from each other in the second direction, and the third portion is positioned between the two fourth portions, the respective first interconnect line is electrically connected to the third portion, and the respective second interconnect line is electrically connected to one of the fourth portions.

In some embodiments, the respective edge busbar includes a fifth portion and a sixth portion spaced apart from each other in the second direction, and the respective first interconnect line is electrically connected to the fifth portion, and the respective second interconnect line is electrically connected to the sixth portion.

In some embodiments, in the second direction, two of the plurality of second interconnect lines adjacent to each other are positioned between the two adjacent first portions.

In some embodiments, at least one of the plurality of intermediate pads is disposed on a respective first portion of the plurality of first portions.

In some embodiments, at least one of the plurality of intermediate pads is disposed on a respective second portion of the plurality of second portions.

In some embodiments, in the first direction, a respective first interconnect line of the first interconnect lines has a first length, a respective second interconnect line of the second interconnect lines has a second length, and the first length is less than the second length.

In some embodiments, in the second direction, a respective first interconnect line of the first interconnect lines has a third width, the respective second interconnect line of the second interconnect lines has a fourth width, and the third width is less than the fourth width.

In some embodiments, in the first direction, a respective intermediate pad of the plurality of intermediate pads has a sixth width, the respective intermediate busbar has a seventh width, and the sixth width is greater than the seventh width.

In some embodiments, in the first direction, a respective intermediate pad of the plurality of intermediate pads has an eighth width, the respective intermediate busbar has a ninth width, and the eighth width is greater than the ninth width.

In some embodiments, a respective portion of the first portions has a tenth width in the first direction, the respective second interconnect line has an eleventh width in the second direction, and the tenth width is less than the eleventh width.

According to some embodiments of the present disclosure, in another aspect, a photovoltaic module is further provided, including: a plurality of cell strings, a respective cell string of the plurality of cell strings formed by connecting a plurality of cells, a respective cell of the cells is the back-contact cell according to the above embodiments; ribbons configured to connect adjacent back-contact cells of the plurality of back-contact cells; at least one encapsulant film configured to cover surfaces of the plurality of back-contact cells; and at least one cover plate configured to cover a surface of the at least one encapsulant film away from the plurality of back-contact cells.

### BRIEF DESCRIPTION OF THE DRAWINGS

One or more embodiments are exemplarily described by figures in corresponding accompanying drawings, and such exemplary description does not constitute a limitation on the embodiments. The figures in the accompanying drawings do not constitute a scale limitation unless otherwise stated. In order to more clearly illustrate technical solutions in the embodiments of the present disclosure or in the prior art, a brief introduction to the accompanying drawings required for the description of the embodiments or the prior art will be provided below. Obviously, the accompanying drawings in the following description are only some of the embodiments of the present disclosure, and those of ordinary skill in the art would also be able to derive other drawings from these drawings without making creative efforts.
FIG. 1 is a schematic structural diagram of a back-contact cell provided in an embodiment of the present disclosure.
FIG. 2 is another schematic structural diagram of a back-contact cell provided in an embodiment of the present disclosure.
FIG. 3 is yet another schematic structural diagram of a back-contact cell provided in an embodiment of the present disclosure.
FIG. 4 is further schematic structural diagram of a back-contact cell provided in an embodiment of the present disclosure.
FIG. 5 is still another schematic structural view of a photovoltaic module according to an embodiment of the present disclosure.
FIG. 6 is one more schematic structural view of a photovoltaic module according to an embodiment of the present disclosure.
FIG. 7 is a schematic diagram of a photovoltaic module according to an embodiment of the present disclosure.

### DETAILED DESCRIPTION OF THE EMBODIMENTS

As can be seen from the background art, the back-contact solar cell has relatively weak current collection capability, which hinders the improvement of its photoelectric conversion efficiency.

In an embodiment of the present disclosure, a back-contact cell and a photovoltaic module are provided, which are at least beneficial to improving the efficiency of the back-contact cell.

In the description of the embodiments of the present disclosure, technical terms "first" and "second" are only used to distinguish different objects and should not be construed as indicating or implying relative importance or implicitly indicating the number, a specific order, or hierarchical relationship of technical features indicated.

In the description of the embodiments of the present disclosure, "a plurality of" means two or more, unless expressly specified otherwise. Similarly, the term "a plurality of groups" refers to two or more groups, and the term "a plurality of pieces" refers to two or more pieces.

When the term "embodiment" is referred to herein, it means that specific features, structures or characteristics described in combination with the embodiment are included in at least one embodiment of the present disclosure. When this phrase occurs at various positions in the specification, it neither necessarily refers to the same embodiment, nor refers to an independent or alternative embodiment mutually exclusive to other embodiments. Those skilled in the art understand both explicitly and implicitly that the embodiments described herein can be combined with other embodiments.

In the description of the embodiments of the present disclosure, the term "and/or" represents merely an association relationship describing associated objects, indicating that there may be three types of relationships, for example, A and/or N, which means three types of situation, that is, the existence of A alone, the existence of both A and N, and the existence of N alone. In addition, the character "/" herein generally indicates that the associated objects are in an "or" relationship.

In the description of the embodiments of the present disclosure, technical terms "center", "longitudinal", "lateral", "length", "width", "thickness", "upper", "lower", "front", " rear", "left", "right", "vertical", "horizontal", "top", "bottom", "inner", "outer", "clockwise", "counterclockwise", "axial", "radial", "circumferential", etc. indicate azimuthal or positional relations based on those shown in the accompanying drawings only for ease of description of the embodiments of the present disclosure and for simplicity of description, and are not intended to indicate or imply that the referenced device or element must have a particular orientation and be constructed and operative in a particular orientation, and thus may not be interpreted as a limitation on the embodiments of the present disclosure. For example, when a device or element illustrated in the drawings is inverted, an element described as being "below", "under", "beneath", or "at the bottom of" another element or feature will be oriented "above" or "at the top of" the other element or feature. Thus, the term "below" may encompass both above and below orientations depending on the context in which the term is used, as will be obvious to those of ordinary skill in the art. Materials may be otherwise oriented, and the spatially relative descriptors used herein may be interpreted accordingly.

In the description of the embodiments of present disclosure, it should be noted that, unless otherwise explicitly specified and defined, the technical terms "mounting", "connecting" and "connection" should be understood in a broad sense, for example, they may be a fixed connection, a detachable connection, or an integrated connection; may be a mechanical connection, or an electrical connection; and may be a direct connection, or an indirect connection via an intermediate medium, or communication inside two elements. For those of ordinary skill in the art, specific meanings of the above terms in the embodiments of the present disclosure could be understood according to specific circumstances.

In the description of the embodiments of the present disclosure, when a component "includes" another component, unless otherwise stated, other components are not excluded, and other components may be further included.

The terminology used in the description of the various embodiments herein is intended solely to describe specific embodiments and is not intended to be limiting. As used in the description of the various embodiments and in the appended claims, the term "component" is intended to include the plural form, unless the context clearly dictates otherwise.

Embodiments of the present disclosure will be described in detail below with reference to accompanying drawings. However, those of ordinary skill in the art may understand that in each embodiment of the present disclosure, many technical details have been put forward in order to make readers better understand the present disclosure. However, even without these technical details and various changes and modifications based on the embodiments below, technical solutions required to be protected by the present disclosure may be implemented.

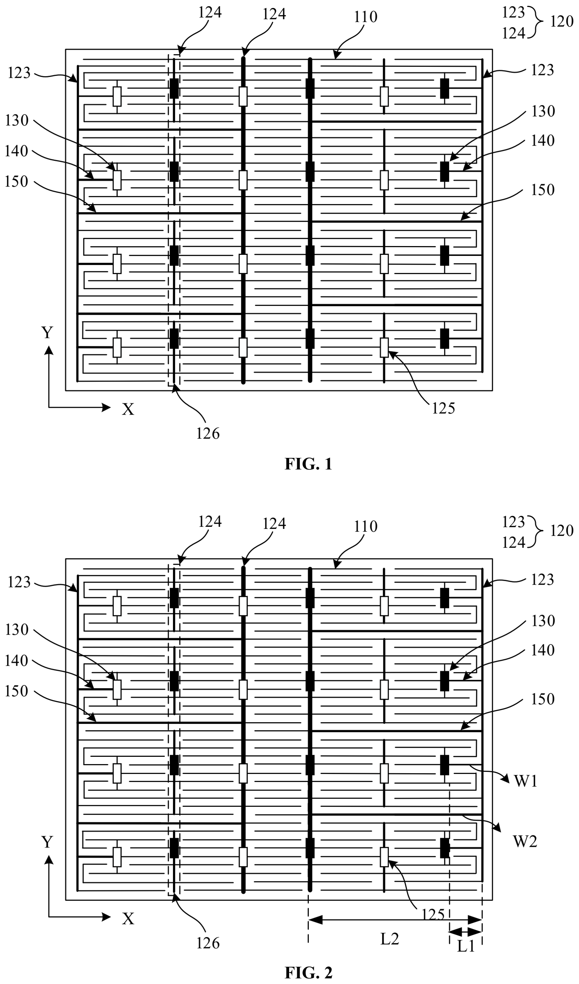

FIGS. 1-5 are different schematic structural diagrams of a back-contact cell provided in some embodiments of the present disclosure.

With reference to FIGS. 1-5, a back-contact cell includes a cell base 100, where the cell base 100 has a first surface 110 and a second surface opposite to each other. It should be noted that the cell base may include a silicon substrate and multiple functional layers formed on the silicon substrate, and the functional layers include, but not limited to, a passivation layer, a doping layer, an anti-reflection coating, conductive layers, and barrier layers.

The back-contact cell provided in the embodiments of the present disclosure has a front side and a back side. The front side serves as the light-receiving surface, and the back side serves as the non-light-receiving surface. The back side of the back-contact cell includes a plurality of fingers 110, a plurality of busbars 120, at least one edge pad 130, at least one first interconnect line 140, and a plurality of second interconnect lines 150.

The fingers 110 extend in the first direction X, and fingers 110 of different polarities are alternately arranged in the second direction Y. Specifically, fingers 110 of a first polarity and fingers 110 of a second polarity are alternately arranged in the second direction Y, where the first polarity is one of the positive electrode or the negative electrode, and the second polarity is the other of the positive electrode or the negative electrode.

The busbars 120 extend in the second direction Y, and busbars 120 of different polarities are alternately arranged along the first direction X. Each busbar 120 is electrically connected to a plurality of fingers 110 of the same polarity arranged along the second direction Y. Specifically, busbars 120 of the first polarity and busbars 122 of the second polarity are alternately arranged in the first direction X; busbars 120 of the first polarity are electrically connected to a plurality of fingers 110 of the first polarity arranged in the second direction Y, and busbars 122 of the second polarity are electrically connected to a plurality of fingers 110 of the second polarity arranged in the second direction Y. Among the busbars 120, those positioned at the two edges of the back-contact cell along the first direction X are edge busbars 123, and the remaining busbars 120 are intermediate busbars 124. The edge busbars 123 may have the first polarity or the second polarity, and the intermediate busbars 124 may have the first polarity or the second polarity. Each intermediate busbar 124 is provided with a plurality of intermediate pads 125. In the first direction X, the width of each intermediate pad 125 is greater than the width of each intermediate busbar 124. At least one of the intermediate busbars 124 closest to the edge busbars 123 include a plurality of interrupted busbars 126 spaced apart from each other, and each interrupted busbar 126 is provided with at least one intermediate pad 125.

The at least one edge pad 130 is positioned at the two edges of the back-contact cell along the first direction X. The distance between the at least one edge pad 130 and the edges of the back-contact cell is greater than the distance between the edge busbars 123 and the edges of the back-contact cell. The at least one first interconnect line 140 extends along the first direction X, and the two ends of each first interconnect line 140 are respectively electrically connected to a corresponding edge pad 130 and a corresponding edge busbar 123.

In some embodiments of the present disclosure, for the sake of distinction, the intermediate pads 125 or the at least one edge pad 130, which are filled in black correspond to the busbars 120 of the first polarity, and the intermediate pads 125 or the at least one edge pad 130, which are filled in white correspond to the busbars 120 of the second polarity.

The second interconnect lines 150 extend along the first direction X. The second interconnect lines 150 connect the edge busbars 123 and at least one intermediate busbar 124 with the same polarity as the edge busbars 123, and the interrupted busbars 126 are located on both sides of the second interconnect lines 150 in the second direction Y. In the second direction Y, the width of each first interconnect line 140 and the width of each second interconnect line 150 are both greater than the width of each finger 110, and the width of each second interconnect line 150 is greater than the width of each first interconnect line 140.

In other words, in some embodiments of the present disclosure, a back-contact cell is provided, and the back-contact cell includes a cell base 100, a plurality of busbars 120, at least one edge pad 130, a plurality of intermediate pads 124, at least one first interconnect line 140 and a plurality of second interconnect lines 150 on the cell base. The plurality of busbars 120 are arranged at intervals in a first direction X, and extend in a second direction Y intersecting the first direction X. The plurality of busbars 120 include two edge busbars 123 and a plurality of intermediate busbars 124 positioned between the two edge busbars 123, where a respective edge pad of the at least one edge pad 130 is closest to and electrically connected to one of the two edge busbars 123 via a respective one of the at least one first interconnect line 140. The plurality of intermediate pads 125 form a plurality of columns spaced apart in the first direction X, and intermediate pads 125 in a respective column of the column are electrically connected to a respective intermediate busbar of the plurality of intermediate busbars 124. A respective edge busbar of the two edge busbars 123 is electrically connected to at least one intermediate busbar of the plurality of intermediate busbars 124 via one or more second interconnect lines of the plurality of second interconnect lines 150.

On the back side of the back-contact cell provided in the embodiments of the present disclosure, the fingers 110 of the first polarity and the fingers 110 of the second polarity are alternately arranged in the second direction Y. The fingers 110 of the first polarity are used to collect either electrons or holes in the back-contact cell, and the busbars 120 of the first polarity are used to collect carriers on the fingers 110 of the first polarity. The fingers 110 of the second polarity are used to collect the other of electrons or holes in the back-contact cell, and the busbars 120 of the second polarity are used to collect carriers on the fingers 110 of the second polarity. Each intermediate busbar 124 is provided with intermediate pads 125, and the intermediate pads 125 are used for soldering with ribbons to transmit the current on the intermediate busbars 124 outward. The edge busbars 123 are electrically connected to the at least one edge pad 130 through the at least one first interconnect line 140, and the at least one edge pad 130 is used for soldering with ribbons to transmit the current on the edge busbars 123 outward. The distance between the at least one edge pad 130 and the edges of the back-contact cell is greater than the distance between the edge busbars 123 and the edges of the back-contact cell. This arrangement avoids the problem of back-contact cell fragmentation caused by excessive welding stress due to the at least one edge pad 130 being too close to the edges of the back-contact cell. However, it also increases the distance that carriers on the edge busbars 123 need to travel, thereby reducing transmission efficiency. Therefore, on the back-contact cell provided in the embodiments of the present disclosure, the edge busbars 123 are further electrically connected to at least one intermediate busbar 124 with the same polarity through the second interconnect lines 150. In this way, the carriers on the edge busbars 123 can be transmitted not only to the ribbons to the edge busbars 123 through the at least one edge pad 130 but also to at least one intermediate busbar 124 with the same polarity via the second interconnect lines 150, and then to the ribbons via the intermediate busbars 124, so as to improve the carrier transmission efficiency of the edge busbars 123. Since both the second interconnect lines 150 and the at least one first interconnect line 140 are electrically connected to the edge busbars 123, and the edge busbars 123 collect carriers from a plurality of fingers 110, setting the widths of each second interconnect line 150 and each first interconnect line 140 to be greater than the width of each finger 110 helps reduce the internal resistance of the second interconnect lines 150 and the at least one first interconnect line 140, thereby improving carrier transmission efficiency. In addition, since the length of each second interconnect line 150 (i.e., L2 as shown in FIG.2) is longer than the length of each first interconnect line 140 (i.e., L1 as shown in FIG.2), resulting in a longer carrier transmission path, setting the width of each second interconnect line 150 (i.e., W2 as shown in FIG.2) to be greater than the width of each first interconnect line 140 (i.e., W1 as shown in FIG.2) helps improve the carrier transmission efficiency in the second interconnect lines 150.

In some embodiments, the back-contact cell is a BC cell, and the BC cell may be an IBC (Interdigitated Back Contact) cell, an HPBC (Hybrid Passivated Back Contact) cell, a TBC cell combining TOPCon (Tunnel Oxide Passivated Contact) technology and IBC technology, or a heterojunction back contact (HBC) cell combining HIT/HJT (Heterojunction Technology) technology and IBC technology, and further may be a back-contact photovoltaic cell of any other type.

In some embodiments, the type of the back-contact cell may be a monocrystalline silicon solar cell, a polycrystalline silicon solar cell, an amorphous silicon solar cell, or a multi-compound solar cell, where the multi-compound solar cell may specifically be a cadmium sulfide solar cell, a gallium arsenide solar cell, a copper indium selenide solar cell, or a perovskite solar cell.

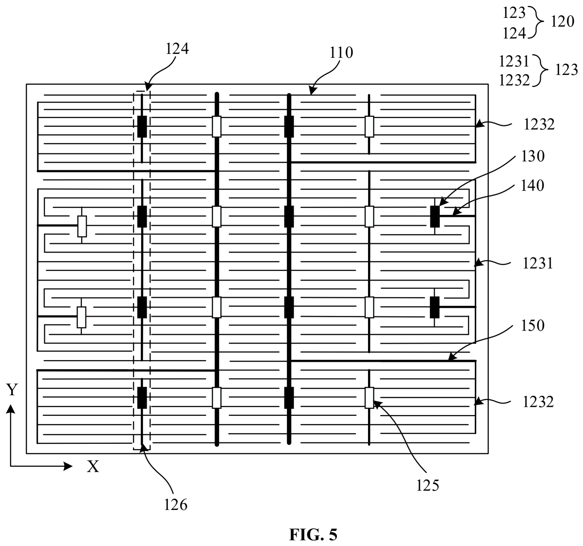

With reference to FIG. 2 or FIG. 5, in some embodiments, in the second direction Y, the total number of the at least one edge pad 130 is less than the number of intermediate pads 125 corresponding to any intermediate busbar 124. Since the corner positions of the back-contact cell are more prone to stress concentration, which causes fragmentation of the back-contact cell, reducing the number of the at least one edge pad 130 can avoid arranging the at least one edge pad 130 at the corner positions of the back-contact cell, thereby reducing the fragmentation risk of the back-contact cell. In addition, the carriers on the edge busbars 123 can be transmitted not only to the ribbons to the edge busbars 123 through the at least one edge pad 130 but also to the ribbons to at least one intermediate busbar 124 with the same polarity through the second interconnect lines 150. Therefore, even if the number of the at least one edge pad 130 is reduced, the carrier collection efficiency on the edge fingers 110 can still be maintained at a high level.

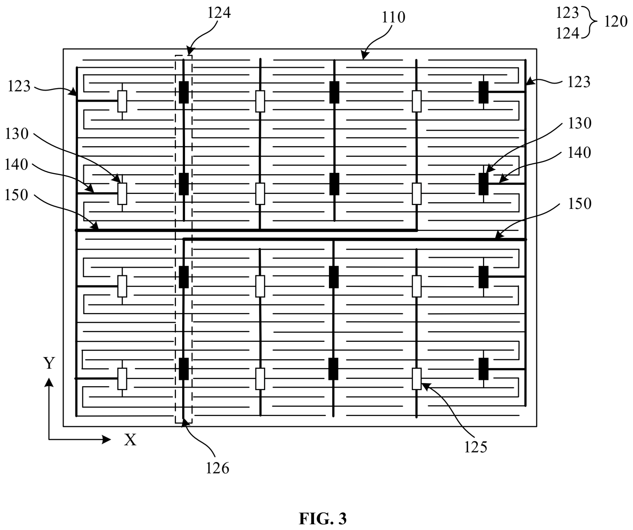

In some embodiments, with reference to FIG. 1, FIG. 2, or FIG. 4, part of the intermediate busbars 124 include a plurality of interrupted busbars 126, and the remaining intermediate busbars 124 are integral. In other embodiments, referring to FIG. 3, all the intermediate busbars 124 may include a plurality of interrupted busbars 126.

When part of the intermediate busbars 124 include a plurality of interrupted busbars 126. In the first direction X, the width of the interrupted busbars 126 may be smaller than the width of the remaining intermediate busbars 124. Since the number of fingers 110 electrically connected to the interrupted busbars 126 is relatively less than the number of fingers 110 electrically connected to the remaining intermediate busbars 124, setting the width of the interrupted busbars 126 to be smaller than the width of the remaining intermediate busbars 124 can save the paste usage cost while maintaining high carrier transmission efficiency of the interrupted busbars 126.

When part of the intermediate busbars 124 include a plurality of interrupted busbars 126. The width of the interrupted busbars 126 in the first direction X and the width of the second interconnect lines 150 in the second direction Y can be determined according to the length of the interrupted busbars 126 and the length of the second interconnect lines 150. For example, when the length of each interrupted busbar 126 in the second direction Y is less than the length of each second interconnect line 150 in the first direction X, the width of each interrupted busbar 126 in the first direction X can be set to be smaller than the width of each second interconnect line 150 in the second direction Y. When the length of each interrupted busbar 126 in the second direction Y is greater than the length of each second interconnect line 150 in the first direction X, the width of each interrupted busbar 126 in the first direction X can be set to be greater than the width of each second interconnect line 150 in the second direction Y. The longer the length of each interrupted busbar 126 or each second interconnect line 150, the longer the corresponding transmission path. Determining the width of each interrupted busbar 126 and the width of each second interconnect line 150 according to their lengths can save the paste usage cost while maintaining high carrier transmission efficiency of both the interrupted busbars 126 and the second interconnect lines 150.

When part of the intermediate busbars 124 include a plurality of interrupted busbars 126. In the first direction X, the width of the edge busbars 123 may be greater than the width of the interrupted busbars 126 and less than the width of the remaining intermediate busbars 124. The carriers on the edge busbars 123 have multiple transmission paths: they can be transmitted to the ribbons to the edge busbars 123 through the at least one edge pad 130, and also to the ribbons corresponding to at least one intermediate busbar 124 with the same polarity through the second interconnect lines 150. Therefore, compared with the intermediate busbars 124 without interrupted busbars 126, the carrier load on the edge busbars 123 is smaller, so the width of the edge busbars 123 may be smaller than that of the intermediate busbars 124 without interrupted busbars 126. However, when the length of each edge busbar 123 is longer than the length of each interrupted busbar 126, the width of each edge busbar 123 needs to be greater than the width of each interrupted busbar 126 to meet the requirement of low internal resistance.

When all the intermediate busbars 124 include a plurality of interrupted busbars 126, each second interconnect line 150 connects a plurality of interrupted busbars 126 with the same polarity arranged in the first direction X, and the width of the second interconnect lines 150 in the second direction Y is greater than the width of the interrupted busbars 126 in the first direction X. That is to say, the second interconnect lines 150 pass through the entire back-contact cell along the first direction X. In this way, the plurality of interrupted busbars 126 with the same polarity arranged in the first direction X are electrically connected to each other, and the carrier transmission path and efficiency on the fingers 110 are improved. The second interconnect line 150 have a longer length, and the width of each second interconnect line in the second direction Y is set to be greater than the width of each interrupted busbar 126 in the first direction X, which can reduce the internal resistance of the second interconnect lines 150 themselves, maintain high carrier transmission efficiency of the second interconnect lines 150, and reduce the paste cost of the interrupted busbars 126.

With reference to FIG. 3, in some embodiments, two second interconnect lines 150 adjacent to each other are provided between two adjacent interrupted busbars 126 in the second direction Y, and the two second interconnect lines 150 adjacent to each other are respectively electrically connected to interrupted busbars 126 of different polarities.

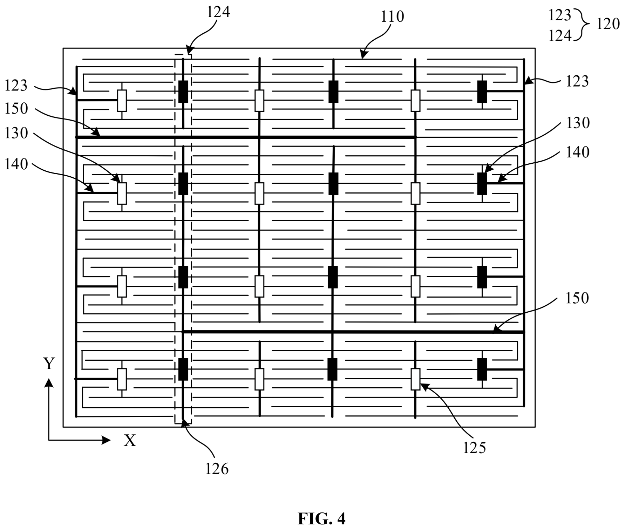

With reference to FIG. 4, in other embodiments, only one second interconnect line 150 may be provided between two adjacent interrupted busbars 126 in the second direction Y. In the second direction Y, the polarities of two adjacent second interconnect lines 150 may be the same or different.

When all the intermediate busbars 124 include a plurality of interrupted busbars 126. In the first direction X, the width of the edge busbars 123 is greater than the width of the interrupted busbars 126. In the second direction Y, the length of each edge busbar 123 is longer than the length of each intermediate busbar 124, so each edge busbar 123 need to be set with a larger width to reduce internal resistance.

In FIGS. 1 to 4, the edge busbars 123 are taken as integral ones for illustration.

In other embodiments, with reference to FIG. 5, each edge busbar 123 includes a first portion 1231 and two second portions 1232 spaced apart from each other in the second direction, and the first portion 1231 is positioned between the two second portions 1232. Each second interconnect line 150 is electrically connected to one of the two second portions 1232, and each first interconnect line 140 is electrically connected to the first portion 1231. Among the fingers 110 located at the edges of the back-contact cell in the first direction X, the fingers 110 close to the corners of the back-contact cell are electrically connected to the two second portions 1232, and the fingers 110 close to the middle of the back-contact cell are electrically connected to the at least one edge pad 130 or the first portion 1231. In this arrangement, no edge pads 130 are provided at the corner positions of the back-contact cell, and the fingers 110 at the corners are electrically connected to other intermediate busbars 124 of the same polarity through the two second portions 1232 and the second interconnect lines 150. The fingers 110 positioned at the edges of the back-contact cell in the first direction X, and the fingers 110 positioned at the middle of the back-contact cell in the second direction Y are electrically connected to the at least one edge pad 130 through the first portion 1231 and the first interconnect line 140 or directly electrically connected to the at least one edge pad 130. Carriers on the fingers 110 at the edges of the back-contact cell in the first direction X are collected through different paths respectively. On one hand, this can improve the carrier collection efficiency on the fingers 110 at the edges; on the other hand, it can avoid arranging pads at the corners of the back-contact cell, thereby preventing the fragmentation of the back-contact cell caused by stress concentration from the pads at the corner positions.

When each edge busbar 123 includes the first portion 1231 and the two second portions 1232. In the first direction X, the width of the first portion 1231 may be smaller than the width of each interrupted busbar 126, and/or the width of each second portion 1232 may be smaller than the width of each interrupted busbar 126. The length of each finger 110 electrically connected to the first portion 1231 or the two second portions 1232 is shorter than the length of each finger 110 electrically connected to the interrupted busbars 126. Therefore, setting the width of the first portion 1231 and/or each second portion 1232 to be smaller helps save the paste usage cost.

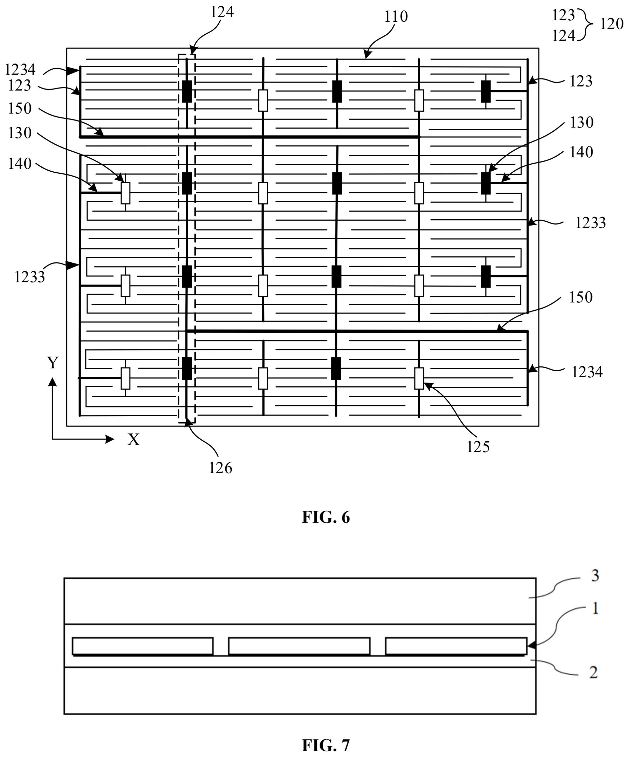

In other embodiments, with reference to FIG. 6, each edge busbar 123 includes a third portion 1233 and a fourth portion 1234 spaced apart from each other in the second direction Y. Each second interconnect line 150 is electrically connected to the fourth portion 1234, and each first interconnect line 140 is electrically connected to the third portion 1233. Among the fingers 110 located at the edges of the back-contact cell, part of the fingers 110 close to the corners of the back-contact cell are electrically connected to the fourth portion 1234, and the fingers 110 close to the middle of the back-contact cell are electrically connected to the at least one edge pad 130 or the third portion 1233. In this arrangement, the fingers 110 at the corners are electrically connected to other intermediate busbars 124 of the same polarity through the fourth portion 1234 and the second interconnect lines 150. The fingers 110 positioned at the edges of the back-contact cell in the first direction X, and the fingers 110 positioned at the middle of the back-contact cell in the second direction Y are electrically connected to the at least one edge pad 130 through the third portion 1233 and the at least one first interconnect line 140 or directly electrically connected to the at least one edge pad 130. Carriers on the fingers 110 at the edges of the back-contact cell along the first direction X are collected through different paths respectively. On one hand, this can improve the carrier collection efficiency on the fingers 110 at the edges; on the other hand, it can avoid arranging pads at the corners of the back-contact cell, thereby preventing the fragmentation of the back-contact cell caused by stress concentration from the pads at the corner positions.

It should be noted that in the accompanying drawings provided in this embodiment, the number of fingers 110, busbars 120, at least one edge pad 130, at least one first interconnect line 140, and second interconnect lines 150 does not constitute a limitation. The number of these components may be adjusted according to actual conditions.

On the back side of the back-contact cell provided in the embodiments of the present disclosure, the fingers 110 of the first polarity and the fingers 110 of the second polarity are alternately arranged in the second direction Y. The fingers 110 of the first polarity are used to collect either electrons or holes in the back-contact cell, and the busbars 120 of the first polarity are used to collect carriers on the fingers 110 of the first polarity. The fingers 110 of the second polarity are used to collect the other of electrons or holes in the back-contact cell, and the busbars 120 of the second polarity are used to collect carriers on the fingers 110 of the second polarity. Each intermediate busbar 124 is provided with a plurality of intermediate pads 125, and the plurality of intermediate pads 125 are used for soldering with ribbons to transmit the current on the intermediate busbars 124 outward. The edge busbars 123 are electrically connected to the at least one edge pad 130 through the at least one first interconnect line 140, and the at least one edge pad 130 is used for soldering with ribbons to transmit the current on the edge busbars 123 outward. The distance between the at least one edge pad 130 and the edges of the back-contact cell is greater than the distance between the edge busbars 123 and the edges of the back-contact cell. This arrangement avoids the problem of back-contact cell fragmentation caused by excessive welding stress due to the at least one edge pad 130 being too close to the edges of the back-contact cell. However, it also increases the distance that carriers on the edge busbars 123 need to travel, thereby reducing transmission efficiency. Therefore, on the back-contact cell provided in the embodiments of the present disclosure, the edge busbars 123 are further electrically connected to at least one intermediate busbar 124 with the same polarity through the second interconnect lines 150. In this way, the carriers on the edge busbars 123 can be transmitted not only to the ribbons corresponding to the edge busbars 123 through the at least one edge pad 130 but also to at least one intermediate busbar 124 with the same polarity through the second interconnect lines 150, and then to the ribbons via the intermediate busbars 124, so as to improve the carrier transmission efficiency of the edge busbars 123. Since both the second interconnect lines 150 and the at least one first interconnect line 140 are electrically connected to the edge busbars 123, and the edge busbars 123 collect carriers from a plurality of fingers 110, setting the widths of the second interconnect lines 150 and the at least one first interconnect line 140 to be greater than the width of the fingers 110 helps reduce the internal resistance of the second interconnect lines 150 and the at least one first interconnect line 140, thereby improving carrier transmission efficiency. In addition, since the length of each second interconnect line 150 is longer than the length of each first interconnect line 140, resulting in a longer carrier transmission path, setting the width of each second interconnect line 150 to be greater than the width of each first interconnect line 140 helps improve the carrier transmission efficiency in the second interconnect lines 150.

Correspondingly, a photovoltaic module is further provided in another embodiment of the present disclosure as shown in FIG. 7. The photovoltaic module includes at least one cell strings 1, ribbons, at least one encapsulant film 2, and at least one cover plate 3. The at least one cell strings 1 is formed by connecting a plurality of cells, where the cells is the back-contact cell as described in the abovementioned embodiments. The ribbons connect the intermediate pads or edge pads of adjacent back-contact cells, and the at least one encapsulant film 2 is configured to cover the surfaces of the back-contact cells, and the at least one cover plate is located on the surface of the at least one encapsulant film 2 away from the back-contact cells. For the description identical or corresponding to the previous embodiment, reference can be made to the corresponding description in the foregoing embodiments, and details are not described again herein.

The encapsulant film may be an organic encapsulant films such as ethylene-vinyl acetate (EVA) films, polyethylene octene copolymer (POE) film, or polyvinyl butyral (PVB) film.

The cover plate may be light-transmitting cover plate such as glass cover plate or a plastic cover plate. In some embodiments, a surface of the cover plate facing the at least one encapsulant film may be a textured surface, thereby enhancing the utilization of incident light.

It may be understood by those skilled in the art that the above embodiments are particular embodiments to implement the present application, and in a practical application, various changes can be made to the form and details without departing from the scope of the present application. Various alterations and modifications may be made by a person skilled in the art without departing from the scope of the present disclosure, and therefore, with regard to the scope of protection of the present disclosure, the scope defined in the claims shall prevail.

## Claims

1. A back-contact cell, comprising:
a cell base;
a plurality of busbars (120) on the cell base, arranged at intervals in a first direction (X) and extending in a second direction (Y) intersecting the first direction (X), the plurality of busbars (120) including two edge busbars (123) and a plurality of intermediate busbars (124) positioned between the two edge busbars (123);
at least one edge pad (130) and a plurality of intermediate pads (125) on the cell base;
at least one first interconnect line (140) and a plurality of second interconnect lines (150) on the cell base;
wherein a respective edge pad of the at least one edge pad (130) is closest to and electrically connected to one of the two edge busbars (123) via a respective one of the at least one first interconnect line (140);
the plurality of intermediate pads (125) form a plurality of columns spaced apart in the first direction (X), and intermediate pads (125) in a respective column of the plurality of columns are electrically connected to a respective intermediate busbar of the plurality of intermediate busbars (124); and
a respective edge busbar of the two edge busbars (123) is electrically connected to at least one intermediate busbar of the plurality of intermediate busbars (124) via one or more second interconnect lines of the plurality of second interconnect lines (150).

2. The back-contact cell according to claim 1, further comprising:
a plurality of fingers (110) forming an array, wherein the array includes a plurality of columns, and each column including fingers extending in the first direction (X) and arranged at intervals in the second direction (Y), and a respective busbar of the plurality of busbars (120) is positioned between and electrically connected to first fingers in a first column and second fingers in a second column adjacent to the first column;
optionally, wherein in the second direction (Y), a respective first interconnect line of the at least one first interconnect line (140) has a first width, a respective finger of the plurality of fingers (110) has a second width, and the first width is greater than the second width;
optionally, wherein in the second direction (Y), a respective second interconnect line of the plurality of second interconnect lines (150) has a third width, and the third width is greater than the second width.

3. The back-contact cell according to claim 1, wherein the plurality of intermediate busbars (124) include two first intermediate busbars respectively adjacent to one of the two edge busbars (123), a respective first intermediate busbar of the two first intermediate busbars includes a plurality of first portions spaced apart in the second direction (Y), and a respective second interconnect line of the plurality of second interconnect lines (150) extends along the first direction (X) and is positioned between two adjacent first portions of the plurality of first portions;
optionally, wherein the plurality of intermediate busbars (124) further includes a plurality of second intermediate busbars other than the first intermediate busbars, and the plurality of second intermediate busbars are positioned between the two first intermediate busbars.

4. The back-contact cell according to any one of claims 1 to 3, wherein the respective second interconnect line (150) is electrically connected to one of the plurality of second intermediate busbars that is closest to the respective first intermediate busbar.

5. The back-contact cell according to any one of claims 1 to 3, wherein at least one of the plurality of second intermediate busbars includes a plurality of second portions spaced apart in the second direction (Y); and
the respective second interconnect line (150) is electrically connected to at least one second portion of the plurality of second portions.

6. The back-contact cell according to claim 5, wherein one part of the second intermediate busbars includes the plurality of second portions, and the other part of the second intermediate busbars are integral second intermediate busbars, and in the first direction (X), a respective second portion of the second portions has a fourth width, and a respective one of the integral second intermediate busbars has a fifth width, and the fourth width is less than the fifth width; or
wherein all the second intermediate busbars (124) include the plurality of second portions grouped into rows, and the respective second interconnect line (150) is electrically connected to second portions in a same row of the rows.

7. The back-contact cell according to any one of claims 1 to 6, wherein the respective edge busbar (123) includes a third portion and two fourth portions spaced apart from each other in the second direction (Y), and the third portion is positioned between the two fourth portions;
the respective first interconnect line (140) is electrically connected to the third portion; and
the respective second interconnect line (150) is electrically connected to one of the fourth portions.

8. The back-contact cell according to any one of claims 1 to 6, wherein the respective edge busbar (123) includes a fifth portion and a sixth portion spaced apart from each other in the second direction (Y);
the respective first interconnect line (140) is electrically connected to the fifth portion; and
the respective second interconnect line is electrically connected to the sixth portion.

9. The back-contact cell according to claim 3, wherein in the second direction (Y), two of the plurality of second interconnect lines (150) adjacent to each other are positioned between the two adjacent first portions.

10. The back-contact cell according to claim 3, wherein at least one of the plurality of intermediate pads (125) is disposed on a respective first portion of the plurality of first portions.

11. The back-contact cell according to claim 5, wherein at least one of the plurality of intermediate pads (125) is disposed on a respective second portion of the plurality of second portions.

12. The back-contact cell according to claim 1, wherein in the first direction, a respective first interconnect line of the at least one first interconnect line (140) has a first length, a respective second interconnect line of the second interconnect lines (150) has a second length, and the first length is less than the second length; and/or
wherein in the second direction (Y), a respective first interconnect line of the at least one first interconnect line (140) has a sixth width, a respective second interconnect line of the second interconnect lines (150) has a seventh width, and the sixth width is less than the seventh width.

13. The back-contact cell according to claim 1, wherein in the first direction, a respective intermediate pad of the plurality of intermediate pads (125) has an eighth width, the respective intermediate busbar (125) has a ninth width, and the eighth width is greater than the ninth width.

14. The back-contact cell according to claim 3, wherein a respective portion of the first portions has a tenth width in the first direction, the respective second interconnect line (150) has an eleventh width in the second direction (Y), and the tenth width is less than the eleventh width.

15. A photovoltaic module, comprising:
a plurality of cell strings (1), a respective cell string of the plurality of cell strings (1) formed by connecting a plurality of cells, a respective cell of the cells is the back-contact cell according to any one of claims 1 to 14;
ribbons configured to connect adjacent back-contact cells of the plurality of back-contact cells;
at least one encapsulant film (2) configured to cover surfaces of the plurality of back-contact cells; and
at least one cover plate (3) configured to cover a surface of the at least one encapsulant film (2) away from the plurality of back-contact cells.
